# EUROPEAN PATENT APPLICATION

(11) **EP 4 773 095 A1**
(43) Date of publication of application: **08.07.2026**
(21) Application number: 25227727.2
(22) Date of filing: 30.12.2025
(51) Int. Cl.: G06V 10/774, G06V 10/82, G06V 20/59

(54) **METHODS AND SYSTEMS FOR AI-BASED GENERATION OF IN-VEHICLE SENSOR DATA**

(30) Priority: 03.01.2025 US 202519009755
(71) Applicant: Harman Becker Automotive Systems, Inc., Novi, MI 48377 (US)
(72) Inventor: Sikander, Saheel Ahamed, 56125 Bangalore (IN)
(74) Representative: Wagner & Geyer

(57) **Abstract**

Systems and methods are herein provided for generation of video data based on previously recorded video data. In one example, a method for generating in-vehicle sensor data comprises obtaining recorded data from one or more in-vehicle sensors positioned in a first vehicle, wherein the recorded data is annotated to indicate one or more landmarks of a subject; determining a current sensor position of the one or more in-vehicle sensors when the recorded data was obtained; obtaining a three-dimensional (3D) model of a second vehicle; determining a target sensor position for newly generated sensor data; generating, based on the recorded data, the current sensor position, the 3D model, and the target sensor position, new sensor data; and outputting the new sensor data to a display device.

## Description

### FIELD

Embodiments of the subject matter disclosed herein relate to in-vehicle cabin sensor data, and more particularly, to generating in-vehicle sensor data based on previously recorded data and 3D vehicle models using AI models.

### BACKGROUND

In vehicle applications, sensor data, including camera video data, is obtained for various purposes, including developing vehicle systems like advanced driver assistance systems(ADASs), training AI-based models (e.g., neural networks), determining driver-specific statistics, validating models and system performances, and the like. However, the sensor data that is obtained is specific to the particular vehicle application, at least in part because of the specific position of the camera. If the position of the camera is changed, even slightly, recorded data is unusable for that specific vehicle application. This results in increased amounts of video data that is to be acquired for purposes like ADAS system development and validation.

### BRIEF DESCRIPTION

In one example, a method for generating in-vehicle sensor data comprises: obtaining recorded data from one or more in-vehicle sensors positioned in a first vehicle, wherein the recorded data is annotated to indicate one or more landmarks of a subject; determining a current sensor position of the one or more in-vehicle sensors when the recorded data was obtained; obtaining a three-dimensional (3D) model of a second vehicle; determining a target sensor position for newly generated sensor data; generating, based on the recorded data, the current sensor position, the 3D model, and the target sensor position, new sensor data; and outputting the new sensor data to a display device.

It should be understood that the brief description above is provided to introduce in simplified form a selection of concepts that are further described in the detailed description. It is not meant to identify key or essential features of the claimed subject matter, the scope of which is defined uniquely by the claims that follow the detailed description. Furthermore, the claimed subject matter is not limited to implementations that solve any disadvantages noted above or in any part of this disclosure.

### BRIEF DESCRIPTION OF THE DRAWINGS

The present invention will be better understood from reading the following description of non-limiting embodiments, with reference to the attached drawings, wherein below:
FIG. 1 shows a block diagram of a computing system configured for generating video data based on previously recorded sensor data and 3D vehicle models;
FIG. 2 shows an exemplary vehicle in which sensor data is recorded;
FIG. 3 shows an exemplary embodiment of a video generation model training system for training a video generation model;
FIG. 4 shows an exemplary process flow diagram for generating new video data from previously acquired video data.
FIG. 5 shows a flowchart illustrating a method for generating new video data using a trained video generation model;
FIG. 6 shows a flowchart illustrating a method for new video data generation based on previously acquired video data and a 3D vehicle model; and
FIG. 7 shows a flowchart illustrating a method for a use-case scenario for updating a vehicle system algorithm based on newly generated video data.

### DETAILED DESCRIPTION

The following description relates to various embodiments of methods and systems for AI-based generation of in-vehicle sensor data. In particular, systems and methods for generating in-vehicle sensor data based on previously recorded data and corresponding sensor positions, a target sensor position, and a target vehicle 3D model are provided. In-vehicle sensor data, such as video/camera data of a driver, is acquired in large amounts for the purpose of development and validation of algorithms and models, such as those used by advanced driver assistance systems (ADASs) and driver monitoring systems, and/or other purposes like statistical analyses. As an example, video data may be acquired and annotated to identify landmarks such as a driver's eye gaze that is then used to train/develop an eye gaze tracking algorithm of a driver monitoring system to assess driver focus, distractibility, health status, and/or the like. Often, the position of the sensor, such as the camera, within the vehicle is fixed and any change in the position renders acquired data unusable for the given application. For example, in an ideal position, the camera may have a view of a driver's face, torso, and arms but when altered, the steering wheel may obstruct view of the patient's torso or the positions of detectable landmarks like the driver's eye gaze may be changed and no longer applicable to the developed algorithms, thus rendering the video data unusable for applications that require such data for execution of the algorithms thereof. Unusable data in this context not only wastes time, it increases the computational power demand on the analysis systems by requiring repeat data acquisition and analysis. Further, sensor data, in some examples, is particular to the specific vehicle in which it was acquired given the fixed sensor positions. Thus, vast amounts of data are needed for multiple vehicle applications.

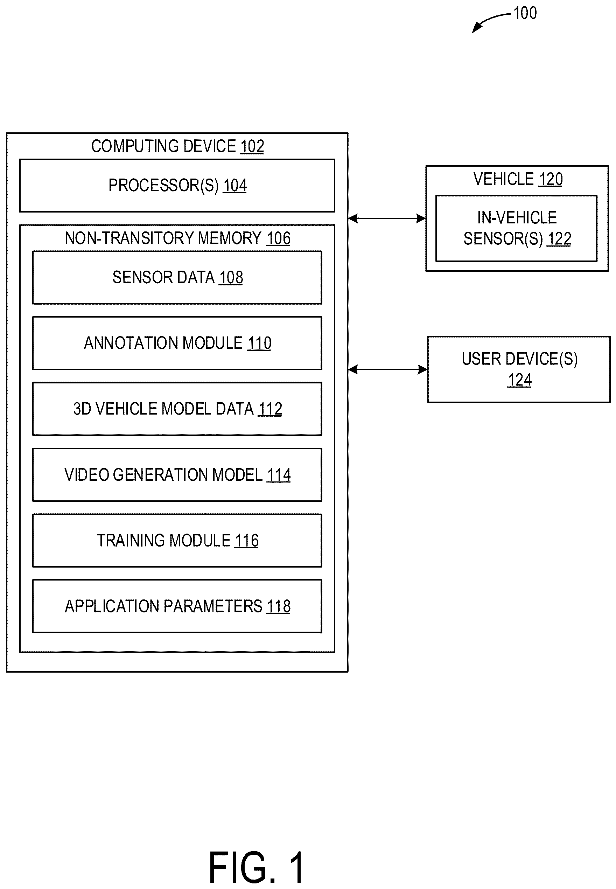

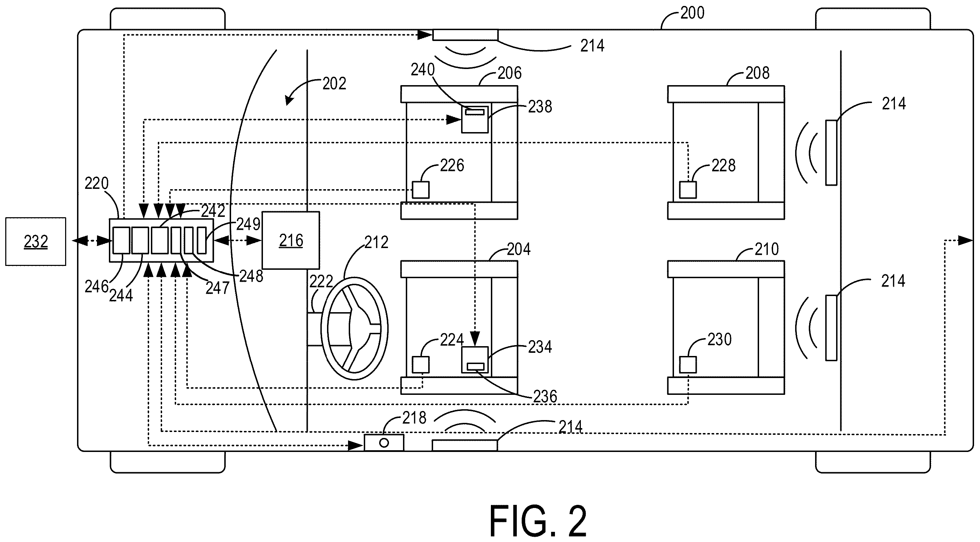

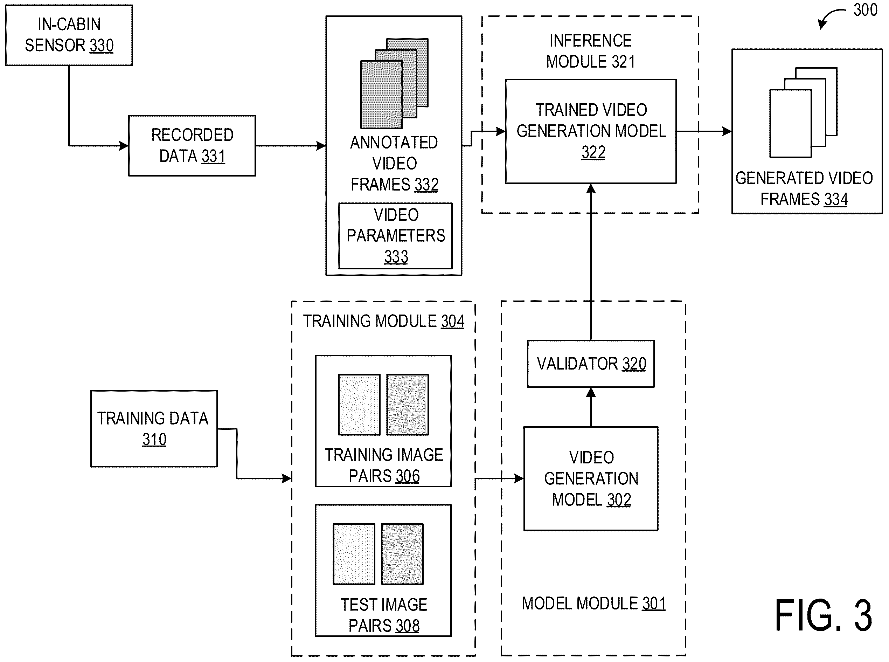

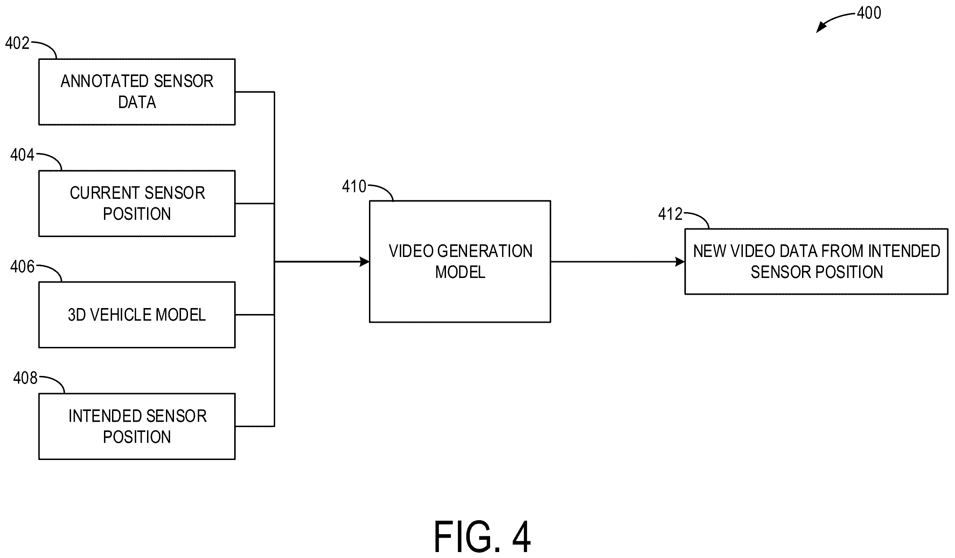

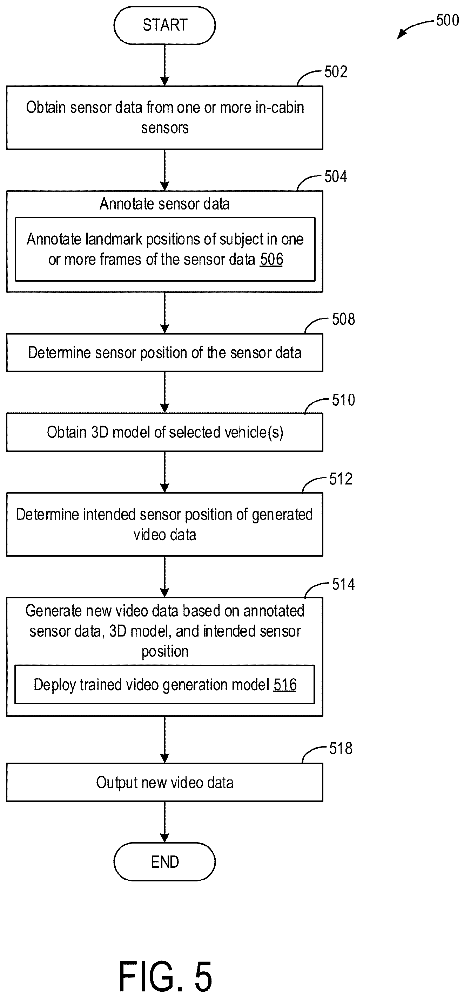

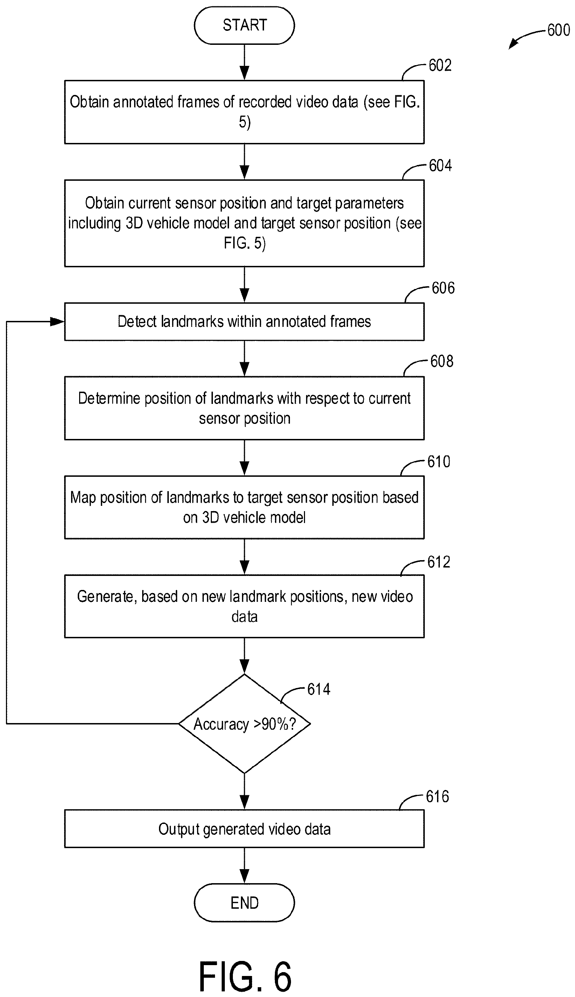

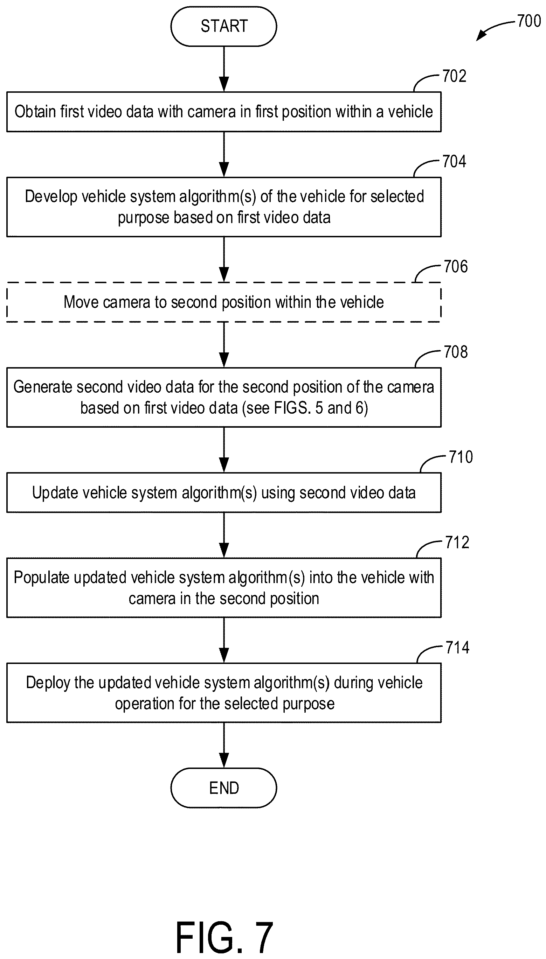

Embodiments are presented herein for methods and systems for AI-based generation of in-vehicle sensor data using 3D vehicle models to at least partially address this issue. The methods and systems will be described, by way of example, with reference to the drawings, wherein: FIG. 1 shows an example computing system for generating in-vehicle sensor data using a video generation model, FIG. 2 shows an exemplary vehicle system from which sensor data, such as video data, may be originally acquired, FIG. 3 shows an example video generation model training system, FIG. 4 shows an example process flow for new sensor data generation, FIG. 5 shows a method for generating new sensor data based on previously acquired sensor data, FIG. 6 shows a flowchart for generating new sensor data using a trained video generation model, and FIG. 7 shows a flowchart for updating a vehicle system such as an ADAS or driver monitoring system, based on newly generated sensor data.

Starting with FIG. 1, a computing system 100 is shown. The computing system 100 may include one or more computing devices, such as computing device 102, in a distributed system. The computing device 102 may comprise one or more processors 104 configured to execute machine readable instructions stored in a non-transitory memory 106. The processor(s) 104 may be any suitable processor, processing unit, or microprocessor, for example. The processor(s) may be a multi-processor system, and, thus, may include one or more additional processors that are identical or similar to each other and that are communicatively coupled via an interconnection bus. Processor(s) 104 may be single core or multi-core, and the programs executed thereon may be configured for parallel or distributed processing. In some embodiments, the processor(s) 104 may optimally include individual components that are distributed throughout two or more devices, which may be remotely located and/or configured for coordinated processing. In some embodiments, one or more aspects of the processor(s) 104 may be virtualized and executed by remotely-accessible networked computing devices configured in a cloud computing configuration.

The non-transitory memory 106 may include one or more data storage structures, such as optical memory devices, magnetic memory devices, or solid-state memory devices, for storing programs and routines executed by the processor(s) 104 of the computing device 102 to carry out various functionalities disclosed herein. The memory may include any desired type of volatile and/or non-volatile memory such as, for example, static random access memory (SRAM) dynamic random access memory (DRAM), flash memory, read-only memory (ROM), etc.

The computing device 102 may be operably and/or communicatively coupled to one or more vehicles, such as vehicle 120. The vehicle 120, as will be further described with respect to FIG. 2, may comprise one or more sensors 122 for driver and occupant monitoring, among other sensors for various vehicle functions. For example, the vehicle 120 may comprise one or more cameras, such as infrared (e.g., near-infrared) cameras adapted for tracking target landmarks like face and eyes of a driver even in low light scenarios, visible light cameras (e.g., RGB cameras) adapted for capturing standard video footage, including tracking target landmarks, of a driver or occupant, time-of-flight sensors adapted for measuring the distance between the sensor and an object (e.g., the driver's face), heat cameras, eye-tracking sensors, capacitive sensors (e.g., for monitoring driver interaction with the steering wheel), ultrasonic sensors, and the like. In the context of video generation as is herein disclosed, sensor data from infrared and visible light cameras may be transmitted to the computing device 102. It should be understood that the vehicle 120 may be a road-vehicle in which data is acquired while the vehicle is on the road or in a simulated driving setting or simulation type vehicle adapted specifically for acquiring data in simulated driving settings.

The non-transitory memory 106 may comprise sensor data 108, which may include the sensor data, such as video data, that has been acquired within the vehicle 120. The sensor data 108 may include the data itself, for example frames of video data, as well as corresponding information such as timestamps, vehicle identifiers (e.g., make, model, etc.), and sensor information, including type of sensor and sensor position.

The non-transitory memory 106 may further comprise annotation module 110, 3D vehicle model data 112, a video generation model 114, a training module 116, and one or more application parameters 118. The annotation module 110 may comprise instructions for annotating the sensor data, including identifying and marking specific landmarks within frames of video data. As an example, an initial frame of a video data stream may be annotated to identify particular regions of interest (ROIs) or landmarks and then the ROIs may be dynamically adjusted based on the subject's movements. As an example, the subject's face, chest, and/or abdomen areas may be identified within a first frame of the video data. A face ROI, a chest ROI and/or an abdomen ROI may be identified and isolated by a segmentation or other object detection algorithm, such as a thresholding-based segmentation algorithm, an edge-based segmentation algorithm, or a regionbased segmentation algorithm. For example, with a thresholding-based segmentation algorithm, increasing the contrast prior to application of the algorithm may increase the accuracy of the segmentation. Dynamically adjusting the ROIs may include analyzing motion within the ROIs, such as applying a sparse motion analysis to estimate motion vector fields in consecutive frames. It should be understood that annotation of landmarks may be performed in other ways, such as via a manual process whereby a human expert identifies and marks landmarks within each frame, or combinations of automated and manual processes, without departing from the scope of this disclosure.

The 3D vehicle model data 112 may include 3D models of a plurality of vehicles. The 3D models may be computer-aided design (CAD) models, in some examples. The 3D models may include models of vehicle interiors and exteriors. The 3D models may be specific to the particular vehicles, by make, model, and year.

The video generation model 114 may include a trained AI-based model, such as a deep neural network, a convolutional neural network, other supervised learning models like regression models, unsupervised learning models, reinforcement learning models, or the like. The training module 116 may comprise instructions for training the video generation model 114. In particular, the training module 116 may include instructions that, when executed by the processor(s) 104, cause the computing system 100 to conduct one or more steps of training the video generation model 114, as will be further described with respect to FIG. 3.

The video generation model 114 may implement one or more specialized neural network architectures and techniques specifically designed for the complex technical challenge of generating accurate synthetic in-vehicle sensor (e.g., video) data. The model utilizes a multi-stream architecture with separate processing pathways for: 1) processing 3D geometric relationships between landmark positions, camera viewpoints, and vehicle cabin geometry using specialized 3D convolution layers, which allows for properly transforming landmark coordinates between different viewpoints while maintaining physical constraints imposed by the vehicle cabin structure; 2) modeling sequential dependencies and motion patterns in the video data using bidirectional LSTM layers, which enables the model to generate temporally coherent video sequences that preserve natural human movement patterns; and 3) preserving find-grained details during the generation process using a specialized loss function that combines reconstruction loss, perceptual loss using pre-trained feature extractors, and adversarial loss to ensure both visual quality and physical accuracy of the generated video data.

To handle the technical challenges specific to in-vehicle environments, the model may implement adaptive normalization layers that account for varying lighting conditions and sensor characteristics (e.g., different types of cameras present in different vehicles), spatial transformers that explicitly model perspective changes between camera viewpoints resulting from different camera positions, physics-informed regularization that enforces constraints on human pose and movement within the vehicle cabin geometry, and multi-scale discriminators that assess realism at different spatial resolutions. This specialized architecture provides for reducing computational requirements compared to generic video generation through efficient feature reuse and model pruning optimized for in-vehicle scenarios, improving generation accuracy through physics-informed constraints, enabling real-time generation of novel viewpoints through optimized model architecture, and ensuring that the generated video data maintains critical properties needed for downstream vehicle system development and validation (e.g., ADAS/driver monitoring system development and validation) through targeted loss functions. The technical implementation allows the system to solve the specific challenges of generating physically accurate synthetic sensor data for automotive applications while significantly reducing computational overhead compared to acquiring and storing real sensor data from multiple vehicle configurations.

The application parameters 118 may include one or more parameters of various applications for sensor data. For example, the various applications may include both the vehicle specifics and the intended use for the sensor data (e.g., development of ADAS, validation of driver monitoring systems, etc.). The vehicle specifics and the intended use of the sensor data may also inform the sensor (e.g., camera) position, which may also be included in the application parameters 118.

The computing device 102 may also be communicatively and/or operably coupled to a user input device 124. The user input device 124 may comprise one or more of a touchscreen, a keyboard, a mouse, a trackpad, a motion sensing camera, and/or other device configured to enable a user to interact with and manipulate data within the computing device 102. The user input device 124 may additionally comprise or be coupled to a display device or display screen, such as a computer monitor. The user input device 124 may be combined with the processor(s) 104 and non-transitory memory 106 in a shared enclosure, or may be a peripheral device.

Turning now to FIG. 2, an exemplary vehicle 200 in which sensor data may be acquired is schematically depicted. The vehicle 200 includes a dashboard 202, a driver seat 204, a first passenger seat 206, a second passenger seat 208, and a third passenger seat 210. In other examples, the vehicle 200 may include more or fewer passenger seats. The driver seat 204 and the first passenger seat 206 are located in a front of the vehicle, proximate to the dashboard 202, and therefore may be referred to as front seats. The second passenger seat 208 and the third passenger seat 210 are located at a rear of the vehicle and may be referred to as back (or rear) seats.

Additionally, the vehicle 200 includes a plurality of integrated speakers 214, which may be arranged around a periphery of the vehicle 200. In some embodiments, the integrated speakers 214 are electronically coupled to an electronic control system of the vehicle, such as to a computing system 220, via a wired connection. In other embodiments the integrated speakers may wirelessly communicate with the computing system 220. As an example, an audio file may be selected by an occupant of the vehicle 200, such as a driver passenger, via a user interface 216, and the selected audio file may be projected via the integrated speakers 214. In some examples, audio alerts may be generated by the computing system 220 and also may be projected by the integrated speakers 214, such as will be elaborated herein.

The vehicle 200 includes a steering wheel 212 and a steering column 222, through which the driver may input steering commands for the vehicle 200. The vehicle 200 further includes one or more cameras 218. The camera 218 as shown may be one of a plurality of in-cabin (e.g., interior) cameras. In the embodiment shown in FIG. 2, the camera 218 is positioned to the side of the driver seat 204, which may aid in monitoring the driver in profile. However, in other examples, the camera 218 may be positioned in other locations in the vehicle, such as on the steering column 222, directly in front of the driver seat 204. Further, the camera 218 may be positioned to the side of the passenger seats 206, 208, 210, or directly in front of the passenger seats 206, 208, and 210. The position of the camera 218 within the vehicle may be fixed, in some examples.

Other cameras or sensors while not show may also be included, such as exterior cameras for aiding in monitoring position of the vehicle within a lane and/or monitoring the position of the vehicle relative to other vehicles.

The camera 218 may include one or more optical (e.g., visible light) cameras, one or more infrared cameras, or a combination of optical and infrared cameras having one or more view angles. In some examples, the camera 218 may have interior view angles as well as exterior view angles. In some examples, the camera 218 may include more than one lens and more than one image sensor. For example, the camera 218 may include a first lens that directs light to a first visible light image sensor (e.g., a charge-coupled device or a metal-oxide-semiconductor) and a second lens that directs light to a second, thermal imaging sensor (e.g., a focal plane array), enabling the camera 218 to collect light of different wavelength range for producing both visible and thermal images. In some examples, the camera 218 may further include a depth camera and/or sensor, such as a time-of-flight camera or a LiDAR sensor.

In some examples, the camera 218 may be a digital camera configured to acquire a series of images (e.g., frames) at a programmable frequency (e.g., frame rate) and may be electronically and/or communicatively coupled to the computing system 220. Further, the camera 218 may output acquired image to the computing system 220 in real-time so that they may be processed in real-time by the computing system 220 and/or a computer network. For example, the images may be processed at a computing device that is communicatively coupled to the vehicle via the computing system 220 (e.g., the computing device 102). As used herein, the term "real-time" denotes a process that occurs instantaneously and without intentional delay. "Real-time" may refer to a response time of less than or equal to about 1 second, for example. In some examples, "real-time" may refer to simultaneous or substantially simultaneous processing, detection, or identification. Further, in some examples, the camera 218 may be calibrated with respect to a world coordinate system (e.g., world space x, y, z). In other examples, the camera 218 may acquire images to determine states, attributes, and poses of the driver or passenger (e.g., occupant), as may be used for development and/or validation of systems such as ADASs and driver monitoring systems, or for statistical analyses or other purposes, as well as for deployment of such ADASs and driver monitoring systems.

The vehicle 200 may further include a driver seat sensor 224 coupled to or within the driver seat 204 and a passenger seat sensor 226 coupled to or within the first passenger seat 206. The back seats may also include seat sensors, such as a passenger seat sensor 228 coupled to the second passenger seat 208 and a passenger seat sensor 230 coupled to the third passenger seat 210. The driver seat sensor 224 and the passenger seat sensor 226 may each include one or a plurality of sensors, such as a weight sensor, a pressure sensor, and one or more seat position sensors that output a measurement signal to the computing system 220. For example, the output of the weight sensor or pressure sensor may be used by the computing system 220 to determine whether or not the respective seat is occupied, and if occupied, a weight of a person occupying the seat. As another example, the output of the one or more seat position sensors may be used by the computing system 220 to determine one or more of a seat height, a longitudinal position with respect to the dashboard 202 and the back seats, and an angle (e.g., tilt) of a back of the corresponding seat.

In some examples, the vehicle 200 further includes a driver seat motor 234 coupled to or positioned within the driver seat 204 and a passenger seat motor 238 coupled to or positioned within the first passenger seat 206. Although not shown, in some embodiments, the back seats may also include seat motors. The driver seat motor 234 may be used to adjust the seat position, including the seat height, the longitudinal seat position, and the angle of the seat back of the driver seat 204 and may include an adjustment input 236. For example, the adjustment input 236 may include one or more toggles, buttons, and switches. The passenger seat motor 238 may be used to adjust the seat position, including the seat height, the longitudinal seat position, and the angle of the seat back of the first passenger seat 206 and may include an adjustment input 240. The adjustment input 240 may include one or more toggles, buttons, and switches. Although not shown, in some embodiments, the back seats may be adjustable in a similar manner.

The computing system 220 may receive inputs via the user interface 216 as well as output information to the user interface 216. The user interface 216 may be included in a digital cockpit, for example, and may include a display and one or more input devices. The one or more input devices may include one or more touchscreens, knobs, dials, hard buttons, and soft buttons for receiving user input from a vehicle occupant.

The computing system 220 includes a processor 242 configured to execute machine readable instructions stored in a memory 244. The processor 242 may be single core or multi-core, and the programs executed by processor 242 may be configured for parallel or distributed processing. In some embodiments, the processor 242 is a microcontroller. The processor 242 may optionally include individual components that are distributed throughout two or more devices, which may be remotely located and/or configured for coordinated processing. In some embodiments, one or more aspects of the processor 242 may be virtualized and executed by remotely-accessible networked computing devices configured in a cloud computing configuration. For example, the computing system 220 may be communicatively coupled with a wireless network 232 via a transceiver 246, and the computing system 220 may communicate with the networked computing devices via the wireless network 232.

The computing system 220 may include a driver monitoring system 247, which may monitor a driver of the vehicle 200. For example, the camera 218 may be located at the front of the vehicle 200 (e.g., on dashboard 202) or on a side of the vehicle 200 next to the driver seat 204, and may be positioned to view a face of the driver. The driver monitoring system may detect facial features of the driver. In some embodiments, the driver monitoring system 247 may be used to retrieve a driver profile of the driver based on the facial features, which may be used to customize a position of the driver seat 204, steering wheel 212, and/or other components or software of the vehicle 200.

The computing system 220 may include an occupant monitoring system 248, which may monitor one or more passengers of the vehicle 200. For example, the camera 218 may be located at a side of the vehicle 200 next to one or more of passenger seats 206, 208, and 210, and may be positioned to view a face of a passenger of the vehicle.

The computing system 220 may include an ADAS 249, which may provide assistance to the driver based at least partially on the driver monitoring system 247. For example, ADAS 249 may receive facial expression data from the driver monitoring system 247, and the ADAS 249 may process the facial expression data to provide the assistance to the driver. For example, the ADAS 249 may process the facial expression data to determine whether the driver appears tired, or stressed. In response to detecting a tired or stressed condition of the driver, the ADAS 249 may alert the driver, or play music, or perform a different action to address the tired or stressed condition of the driver. The ADAS 249 may be developed and/or validated based on data acquired by the cameras 218 and/or other cameras like externally facing cameras, in some examples.

Additionally or alternatively, the computing system 220 may directly communicate with the networked computing devices via short-range communication protocols, such as Bluetooth^{®}. In some embodiments, the computing system 220 may include other electronic components capable of carrying out processing functions, such as a digital signal processor, a field-programmable gate array (FPGA), or a graphic board. In some embodiments, the processor 242 may include multiple electronic components capable of carrying out processing functions. For example, the processor 242 may include two or more electronic components selected from a plurality of possible electronic components, including a central processor, a digital signal processor, a field-programmable gate array, and a graphics board. In still further embodiments, the processor 242 may be configured as a graphical processing unit (GPU), including parallel computing architecture and parallel processing capabilities.

Further, the memory 244 may include any non-transitory tangible computer readable medium in which programming instructions are stored. As used herein, the term "tangible computer readable medium" is expressly defined to include any type of computer readable storage. The example methods described herein may be implemented using coded instruction (e.g., computer readable instructions) stored on a non-transitory computer readable medium such as a flash memory, a read-only memory (ROM), a random-access memory (RAM), a cache, or any other storage media in which information is stored for any duration (e.g. for extended period time periods, permanently, brief instances, for temporarily buffering, and/or for caching of the information).

Computer memory of computer readable storage mediums as referenced herein may include volatile and non-volatile or removable and non-removable media for a storage of electronically formatted information, such as computer readable program instructions or modules of computer readable program instructions, data, etc. that may be stand-alone or as part of a computing device. Examples of computer memory may include any other medium which can be used to store the desired electronic format of information and which can be accessed by the processor or processors or at least a portion of a computing device. In various embodiments, the memory 244 may include an SD memory card, an internal and/or external hard disk, USB memory device, or a similar modular memory.

Sensor data that is acquired by the vehicle 200, for example video data acquired by the cameras 218 may be transmitted to an external computing system, such as computing system 100 of FIG. 1, either in real-time via a wireless connection or in batches delayed after acquisition. For example, the video data may be stored in the memory 244 of the vehicle 200 and then downloaded and/or offloaded to the computing system 100.

Further still, in some examples, the computing system 220 may include a plurality of sub-systems or modules tasks with performing specific functions related to performing image acquisition and analysis. As used herein, the terms "system," "unit," or "module" may include a hardware and/or software system that operates to perform one or more functions. For example, a module, unit, or system may include a computer processor, controller, or other logic-based device that performs operations based on instructions stored on a tangible and non-transitory computer readable storage medium, such as a computer memory. Alternatively, a module, unit, or system may include a hard-wired device that performs operations based on hard-wired logic of the device. Various modules or units shown in the attached figures may represent the hardware that operates based on software or hardwired instructions, the software that directs hardware to perform the operations, or a combination thereof.

Turning now to FIG. 3, an example of a video generation model training system 300 is shown, which may be used to train a video generation model 302. The video generation model 302 may be trained to generate new video data from previously acquired video data, in accordance with one or more operations described in greater details below. The video generation model training system 300 may be implemented by a computing device, such as computing device 102 of FIG. 1, to train the video generation model 302 to generate new video data from previously acquired video data.

In some examples, the video generation model 302 may be a neural network, such as a deep neural network, a convolutional neural network, or the like with a plurality of hidden layers.

The video generation model 302 may be stored within a model module 301 of the computing system. The video generation model training system 300 also includes a training module 304, which includes a training dataset comprising a plurality of training pairs of data, such as image pairs divided into training image pairs 306 and test image pairs 308. Training module 304 may be a non-limiting example of training module 116 of computing device 102 of FIG. 1.

A number of training image pairs 306 and test image pairs 308 may be selected to ensure that sufficient training data is available to prevent overfitting, whereby the video generation model 302 learns to map features specific to samples of training set that are not present in the test set.

Each image pair of the training image pairs 306 and the test image pairs 308 comprises an input image and a target image. The input image and the target image may be in-cabin images (e.g., images acquired within a cabin of a vehicle by an in-cabin camera sensor), including both infrared and RGB images, or simulated images generated from RGB or infrared reference images not acquired in a vehicle cabin. The input images and target images may be stored and/or generated by a training data generator 310. The training data generator 310 may be used to generate the training image pairs 306 and the test image pairs 308 of the training module 304.

Once each image pair is generated, the image pair may be assigned to either the training image pairs 306 or the test image pairs 308. In an embodiment, the image pair may be assigned to either the training image pairs 306 or the test image pairs 308 randomly in a preestablished proportion. For example, the image pair may be assigned to either the training image pairs 306 or the test image pairs 308 randomly such that 90% of the image pairs generated are assigned to the training image pairs 306, and 10% of the image pairs generated are assigned to the test image pairs 308. Alternatively, the image pair may be assigned to either the training image pairs 306 or the test image pairs 308 randomly such that 85% of the image pairs generated are assigned to the training image pairs 306, and 15% of the image pairs generated are assigned to the test image pairs 308. It should be appreciated that the examples provided herein are for illustrative purposes, and image pairs may be assigned to the training image pairs 306 dataset or the test image pairs 308 dataset via a different procedure and/or in a different proportion without departing from the scope of this disclosure.

Video generation model training system 300 may include a validator 320 that validates the performance of the video generation model 302 against the test image pairs 308. The validator 320 may take as input a partially trained video generation model 302 and a dataset of test image pairs 308, and may output an assessment of the performance of the partially trained video generation model 302 on the dataset of test image pairs 308.

Once the video generation model 302 has been validated, a trained video generation model 322 (e.g., the validated video generation model 302) may be used to generate new video data (e.g., generated video frames 334) from previously acquired video data based on a 3D vehicle model and other parameters. For example, an in-cabin sensor 330, such as an infrared or RGB camera, may acquire recorded data 331 of the interior of a vehicle, as previously discussed. The recorded data 331 may be annotated, via a manual and/or automated process as is discussed above to generate annotated video frames 332. The annotated video frames 332, as well as video parameters 333, may be fed to the trained video generation model 322. The video parameters 333 may include a camera position that corresponds to the recorded data, a target camera position for a select application, and a 3D vehicle model for the select application. The trained video generation model 322 may be stored within an inference module 321 of the computing device.

In some examples, the video generation model may be trained on a plurality of 3D vehicle models and camera positions within the plurality of 3D vehicle models, wherein synchronized video frames from pairs of vehicles and/or pairs of cameras, or combinations thereof, capture the same scene. Ground truth for the landmark's position in both frames may be defined and the model may be trained to map landmarks from one coordinate system to another and/or within the same coordinate system with the camera at different orientations/positions.

Turning now to FIG. 4, a process flow 400 for generating new video frames is shown. In the process flow 400, annotated sensor data 402, a current sensor position 404, a 3D vehicle model 406, and an intended or target sensor position 408 may be provided to a video generation model 410. The annotated sensor data 402 may comprise a plurality of image frames of video data, each frame being annotated to denote landmarks such as eyes, face, chest, and the like of an occupant such as a driver. The frames may be annotated manually by a human expert, by an automated algorithm, or by a combination thereof. The video data may be acquired within a vehicle by an in-cabin sensor such as an infrared or visible light camera. The current sensor position 404 may be the position of the in-cabin sensor when the video data to which the annotated sensor data 402 corresponds was acquired.

The 3D vehicle model 406, such as a CAD model, may be of a target vehicle. The vehicle to which the annotated sensor data 402 corresponds may be a first vehicle and the target vehicle may be a second, different vehicle, in some examples (e.g. different make, model, and year). In other examples, the first and second vehicles may be the same type of vehicles (e.g., same make, model, and year). The intended sensor position 408 may be the position of the in-cabin camera that newly generated video frames correspond to (e.g., image frames generated from the angle of the intended sensor position). The intended sensor position 408 may be particular to the intended application of the newly generated video frames, including the specific vehicle (e.g., the second vehicle) and the end use, such as ADAS development, driver monitoring system validation, etc. The video generation model 410, based on the inputs, may output new video data from the intended sensor position, as noted at 412.

Turning now to FIG. 5, a flowchart illustrating a method 500 for generating new video data from previously acquired in-vehicle video data. Method 500 may be executed by a processor of a computing device, such as computing device 102 of FIG. 1. Some operations of method 500 may be stored in a non-transitory memory of the computing device (e.g., non-transitory memory 106 of FIG. 1) and executed by a processor of the computing device (e.g., processor(s) 104). In various embodiments, the video generation model used to generate new video data may be trained as described above.

At 502, method 500 includes obtaining sensor data from one or more in-cabin sensors of a first vehicle. The one or more in-cabin sensors may be one or more in-cabin (e.g., cabin interior facing) cameras, including RGB cameras and/or infrared cameras. The sensor data may be obtained by the one or more in-cabin sensors and either transmitted in real-time to the computing device herein described or stored in memory of a vehicle computing system of the first vehicle and then offloaded or downloaded to the computing device herein described in batches. The sensor data may also be referred to herein as previously acquired sensor data or current sensor data.

At 504, method 500 includes annotating the sensor data. Annotating the sensor data, as described with respect to FIG. 1, may include annotating landmark positions of a subject, such as a driver or other occupant, in one or more frames of the sensor data, as noted at 506. As described above, annotating landmarks may be a manual process executed by a human expert using a user input device coupled to the computing device, an automated process executed via an algorithm, or a combination thereof. For example, in a first frame of the one or more frames of the sensor data, a segmentation algorithm may be applied to identify ROIs, which may be marked as landmarks. Motion of the ROIs may be detected via a sparse motion analysis in order to dynamically adjust the position of the ROIs within subsequent frames. Alternatively or additionally, a human expert may manually select landmarks within individual frames.

At 508, method 500 includes determining a sensor position that corresponds to the sensor data. As herein described, the one or more in-cabin sensors may have fixed positions and thus the acquired sensor data (e.g., video image frames) may correspond to those positions. As an example, the sensor data may be acquired in a known vehicle space (e.g., of the first vehicle), for example determined via a corresponding 3D vehicle model. Based on the sensor data and the known vehicle space, the sensor orientation, including pitch, yaw, and roll, and position, such as on A-Pillar, steering column, rear view mirror, or the like, are determined.

At 510, method 500 includes obtaining a 3D model of a selected vehicle. The selected vehicle may be the vehicle in which the newly generated video data may ultimately be set. For example, if the newly generated video data is to be used to update a vehicle system algorithm of the same vehicle from which the sensor data was obtained at 502, the selected vehicle may be the first vehicle. In other examples, the newly generated video data may be used to develop a vehicle system algorithm of a different vehicle (e.g., not the first vehicle) and the selected vehicle may be the different vehicle. Thus, the selected vehicle may be selected according to an end use application for the newly generated video data. Further, the selected vehicle may be selected by a user, for example via a user input device from a list displayed on display device thereof. The 3D model of the vehicle may be a CAD model or other type of software based 3D model. Further it should be understood that 2D or 4D models may also be used without departing from the scope of this disclosure. The 3D vehicle model may be obtained from a library of available 3D models (e.g., the 3D vehicle model data 112 of FIG. 1).

At 512, method 500 includes determining an intended or target sensor position of generated video data. The intended or target sensor position may be different from the sensor position of the previously acquired sensor data in some examples. In other examples, the intended or target sensor position may be the same as the sensor position of the previously acquired sensor data. As an example, new sensor data may be generated for a different camera position within the same vehicle, for which the 3D vehicle model of the vehicle that corresponds to the previously acquired sensor data may be obtained. Such may be the case when the camera position of the previously acquired sensor data is misaligned or otherwise moved to a second position, wherein new video data based on the previously acquired sensor data may be generated with the intended camera position without having to re-acquire sensor data. In another example, new sensor data may be generated for a different vehicle with a different or the same camera position. The 3D vehicle model may thus be obtained for the intended vehicle and the new video data may be generated based on the previously acquired sensor data without having to acquire new video data in the different vehicle. In this way, computational demands for both the vehicle computing system and the computing device may be reduced, as well as reducing the time and cost needed to acquire in-vehicle data.

At 514, method 500 includes generating the new video data based on the annotated sensor data, the 3D model of the intended vehicle, and the intended sensor position. In some examples, generating the new video data may comprise deploying the trained video generation model, as noted at 516. As will be further described with respect to FIG. 6, the model may generate the new video data by mapping the landmarks from the annotated previously acquired data to the 3D vehicle model based on the intended sensor position.

At 518, method 500 includes outputting the new video data. The new video data may be outputted for display on a display device of the user input device that is operably and/or communicatively coupled to the computing device. Users may then view the new video data. Further, the new video data may be outputted to systems for development and/or validation of in-vehicle systems such as ADASs and driver monitoring systems and/or to systems for analysis (e.g., statistical analysis) of driver and/or occupant behaviors.

In this way, video data of drivers and occupants may be generated from previously acquired data without having to actually acquire the new data with cameras within the vehicle. For example, when an in-cabin camera is malpositioned, thus rendering the data it acquires unusable, the data acquired may be used to generate new data from the intended camera position. Similarly, instead of acquiring new, large size files of video data with in-cabin cameras of different vehicles, previously acquired video data from a first vehicle may be used to generate new video data for the different vehicles.

Turning now to FIG. 6, a flowchart illustrating a method 600 for generating new video data with a trained video generation model is shown. Method 600 may be executed by a processor of a computing device, such as computing device 102 of FIG. 1. Some operations of method 600 may be stored in a non-transitory memory of the computing device (e.g., non-transitory memory 106 of FIG. 1) and executed by a processor of the computing device (e.g., processor(s) 104). In various embodiments, the video generation model used to generate new video data may be trained as described above. The method 600 may be incorporated as a portion of a method, such as at 514 of method 500.

At 602, method 600 includes obtaining annotated frames of recorded video data, also referred to herein as previously acquired sensor data. As described with respect to FIG. 5, the recorded video data may be acquired by one or more in-cabin cameras at fixed positions within a first vehicle and then transmitted to the computing device. The recorded video data may be annotated to denote one or more landmarks in frames of the recorded video data.

At 604, method 600 includes obtaining a current sensor position and target parameters including a 3D vehicle model and a target sensor position, as described with respect to FIG. 5. The current sensor position may be the sensor position in which the recorded video data was obtained. The 3D vehicle model may correspond to a target vehicle, which may be different or the same as the first vehicle, and the target sensor position may be different or the same as the current sensor position.

At 606, method 600 includes detecting landmarks within the annotated frames with the trained video generation model. As noted above, the annotated frames may be annotated to denote one or more landmarks, such as eyes, face, chest, and the like. These denoted landmarks may be detected based on bounding boxes and the ground truth generated during annotation of the frames.

At 608, method 600 includes determining the position of the landmarks with respect to the current sensor position with the trained video generation model. As an example, the position of the landmarks may be considered with respect to 3D space in relation to the current sensor position. For example, a face detection model may reconstruct the landmarks relative to pitch, yaw, and roll and position of the sensor within the vehicle coordinate system.

At 610, method 600 includes mapping the position of the landmarks to the target sensor position based on the 3D vehicle model with the trained video generation model. Mapping the position of the landmarks may thus assign the landmarks to positions within the 3D space of the 3D vehicle model with respect to the target sensor position. For example, the coordinate system of the vehicle that corresponds to the sensor data and current sensor position may be related to the coordinate system of the 3D vehicle model of the target vehicle and target sensor position, which may include estimating a geometric transformation, such as rotation, translation, scaling, and the like. The scene geometry provided by the 3D vehicle model may inform this mapping process. The coordinates of the designated landmark within the originally acquired sensor data may be mapped to the coordinate system of the 3D vehicle model. The trained video generation model may predict a direct coordinate transformation and/or a heat map or probabilistic distribution over the possible locations in the generated frames to allow for an uncertainty estimation, in some examples. The video generation model may then synthesize the new video frames within the target vehicle's coordinate system provided by the 3D vehicle model, ensuring the geometry of the vehicle interior and that the perspective of the target sensor aligns with this geometry.

At 612, method 600 includes generating, based on the new landmark positions, new video data with the trained video generation model. The new video data may be generated in the context of the 3D vehicle model including the one or more landmarked positioned in the new positions with respect to the target sensor position. For example, the 3D vehicle model may inform the specific vehicle cabin geometry in which the new video data is generated. The generated video data may be generated as a series of sequential image frames, similar to the frames of the recorded video data.

At 614, method 600 includes determining whether the accuracy of the trained video generation model is greater than 90%. Determining the accuracy of the model may be based on one or more Key Performance Indicators (KPIs) tailored to assess the quality, fidelity, and relevance of the generated frames. These KPIs may measure the model's success in generating frames that align with the desired outcomes. As an example, one or more metrics may be used to evaluate the visual features of the generated frames, including signal-to-noise ratio (SNR), structural similarity between the generated frames, the 3D vehicle model, and the frames of the annotated recorded video data, which may be considered the ground truth. Content accuracy may also be assessed by comparing the content of the generated frames with ground truth labels or descriptions. If the accuracy is greater than 90%, method 600 proceeds to 616. If the accuracy is less than 90%, method 600 returns to 606 to repeat generation of the frames.

At 616, method 600 includes outputting the generated video data. The generated video data may be outputted for display on a display device for user viewing as previously discussed. Further, the generated video data may be outputted to systems for development and/or validation of in-vehicle systems such as ADASs and driver monitoring systems and/or to systems for analysis (e.g., statistical analysis) of driver and/or occupant behaviors.

Turning now to FIG. 7, a flowchart illustrating a method 700 for a use-case scenario for updating vehicle system algorithm(s) based on newly generated sensor data is shown. Method 700 may be executed at least in part by a processor of a computing device, such as computing device 102 of FIG. 1. Some operations of method 700 may be stored in a non-transitory memory of the computing device (e.g., non-transitory memory 106 of FIG. 1) and executed by a processor of the computing device (e.g., processor(s) 104). In some examples, some operations of the method 700 may be executed by a computing device integrated in the vehicle, for example a computing device that stores and executes algorithms for vehicle systems including an ADAS and/or a driver monitoring system.

At 702, method 700 includes obtaining first video data with a camera in a first position within a vehicle. The first video data may include one or more landmarks such as face, eyes, torso, and the like. The first video data may be annotated manually, in an automated fashion via one or more processes (e.g., edge detection algorithms, motion analysis algorithms, etc.), or via a combination of manual and automated annotation.

At 704, method 700 includes developing one or more vehicle system algorithms of the vehicle for a selected purpose based on the first video data. As an example, a driver monitoring system algorithm for analysis of driver states such as alert, drowsy, and distracted based on driver eye gaze may be developed based on the video data. In such an example, the video data may be annotated to identify landmarks including the driver's eyes for eye gaze tracking. The eye gaze tracking algorithm of the driver monitoring system may thus be developed to detect eye gaze of the driver to identify various driver states. Other algorithms with other purposes, such as analysis of respiratory patterns, may also be developed based on the same video data or different video data. At 706, method 700 includes moving the camera to a second position within the vehicle. Moving the camera may be an intentional or unintentional action. For example, the driver may accidentally move the camera to the second position while adjusting a rear view mirror. The vehicle system algorithm(s) may be developed at 704 for the first camera position and thus may not be applicable, or may otherwise render inaccurate results, based on data collected with the camera in the second position. As an example, an eye gaze algorithm of a driver monitoring system may be developed to identify a driver distracted state when the eye gaze of the driver is 30 degrees rotated from a designated forward position for longer than a predefined duration. The metric of 30 degrees may be dependent upon the position/orientation of the camera in the first position, wherein the designated forward position is defined according to the position of the camera. When the camera is moved to the second position, the eye gaze algorithm may under or over detect a distracted state due to the change in camera position relative to the unchanged position of the driver and range of rotation of the driver's eyes.

At 708, method 700 includes generating second video data for the second position of the camera based on the first video data. As described with respect to FIGS. 5 and 6, generating new video data may include ingesting previously acquired video data (e.g., the first video data), the position of the camera that corresponds to the previously acquired video data (e.g., the first position of the camera), and a 3D model of the vehicle and feeding them into a trained video generation model. The video generation model may map landmarks of the first video data taken at the first camera position to the second camera position within the geometry of the vehicle, as described above.

At 710, method 700 includes updating the vehicle system algorithm(s) using the second video data. The vehicle system algorithm(s) that were developed based on the first video data may be updated based on the second video data to allow the algorithm to adjust for the change in camera position. Updating the vehicle system algorithm(s) based on the second video data that is generated based on the first video data may mitigate having to entirely redevelop the algorithms with newly acquired video data, thereby reducing processing demands and increasing efficiency of the computing device. Further, the need to reacquire new video data may be mitigating, which reduces demanded time and processing resources.

At 712, method 700 includes populating the updated vehicle system algorithm(s) into the vehicle with the camera in the second position. As noted above, the originally developed algorithm(s) may yield inaccurate or unusable outputs based on data acquired with the camera in the second position. However, the updated algorithm(s) may be updated based on the second video data so as to allow for accurate outputs. To use the example presented above, an updated eye gaze algorithm may be configured for detection of a distracted state when eye gaze is 30 degrees displaced from a designated forward position for a predefined duration, wherein the 30 degrees and the designated forward position are updated to correspond to the second camera position rather than the first camera position.

At 714, method 700 includes deploying the updated vehicle system algorithm(s) during vehicle operation for the selected purpose. Thus, as described above, the updated algorithm(s) may be usable with the second camera position and may yield usable and more accurate outputs.

Generating video data based on previously acquired video data in this way may reduce time spent in data acquisition and may mitigate unusable data by repurposing/transforming the data. Further, using the generated video data to update previously developed algorithms may mitigate the need to redevelop/retrain algorithms, thereby increasing processing efficiency of the computing system used to develop the algorithms.

It should be understood that the method 700 herein described and other methods may be performed. For example, in a scenario for generating video data based on video data acquired in a first vehicle to be used to develop an algorithm for a second vehicle, a method may include: 1) obtaining first video data with a first camera in a first position within a first vehicle; 2) developing a vehicle system algorithm of the first vehicle for a selected purpose based on the first video data; 3) generating second video data for a second camera in a second position within a second vehicle based on the first video data; 4) updating the vehicle system algorithm for the second vehicle using the second video data; 5) populating the updated vehicle system algorithm into the second vehicle with the second camera in the second position; and 6) deploying the updated vehicle system algorithm during operation of the second vehicle for the selected purpose. These steps may be similar to those described above with respect to FIG. 7, thus allowing for updating a vehicle system algorithm developed for a first vehicle to be used in a second vehicle without having to acquire new video data and develop an entirely new algorithm, thus reducing processing demands, increasing efficiency, and saving time.

The technical effect of the systems and methods herein described is that the amount of video data that has to be acquired within vehicles may be reduced by using previously recorded data to generate new data in different settings (e.g., for different vehicles and/or with sensors at different positions). Further, when video data is acquired within a vehicle with the camera not in the proper position, what would otherwise be unusable video data may be used to generate useful data from the intended vehicle position using the 3D model of the vehicle. In this way, repeated acquisitions of video data may be reduced.

The disclosure also provides support for a method for generating in-vehicle sensor data, comprising: obtaining recorded data from one or more in-vehicle sensors positioned in a first vehicle, wherein the recorded data is annotated to indicate one or more landmarks of a subject, determining a current sensor position of the one or more in-vehicle sensors when the recorded data was obtained, obtaining a three-dimensional (3D) model of a second vehicle, determining a target sensor position for newly generated sensor data, generating, based on the recorded data, the current sensor position, the 3D model, and the target sensor position, new sensor data, and outputting the new sensor data. In a first example of the method, generating the new sensor data comprises deploying a trained video generation model. In a second example of the method, optionally including the first example, the first and second vehicles are the same vehicle. In a third example of the method, optionally including one or both of the first and second examples, the recorded data comprises a plurality of annotated frames. In a fourth example of the method, optionally including one or more or each of the first through third examples, generating the new sensor data comprises deploying a video generation model to: detect the one or more landmarks within the plurality of annotated frames, determine a position of each of the one or more landmarks with respect to the current sensor position, map the position of each of the one or more landmarks to the target sensor position based on the 3D model of the second vehicle to determine new landmark positions, and generate, based on the new landmark positions, the new sensor data. In a fifth example of the method, optionally including one or more or each of the first through fourth examples, the first and second vehicles are different vehicles. In a sixth example of the method, optionally including one or more or each of the first through fifth examples, the target sensor position is different from the current sensor position. In a seventh example of the method, optionally including one or more or each of the first through sixth examples, the sensor data is video data and the one or more in-vehicle sensors are cameras mounted in a cabin of the first vehicle.

The disclosure also provides support for a method for a vehicle, comprising: acquiring first video data with a camera mounted in a first position in a cabin of the vehicle, developing a vehicle system algorithm for the vehicle based on the first video data, generating second video data based on the first video data for a second position of the camera within the cabin of the vehicle, wherein the second video data is generated by a video generation model based on the first video data, the first position of the camera, and a 3D model of the vehicle, updating the vehicle system algorithm using the second video data, populating the updated vehicle system algorithm into the vehicle with the camera in the second position, and following population of the updated vehicle system algorithm, deploying the updated vehicle system algorithm during operation of the vehicle. In a first example of the method, the video generation model is trained on synchronized video frames of a plurality of 3D vehicle models and camera positions within the plurality of 3D vehicle models. In a second example of the method, optionally including the first example, the 3D model of the vehicle is a computer aided-design (CAD) model. In a third example of the method, optionally including one or both of the first and second examples, the video generation model is configured to: detect one or more annotated landmarks within annotated frames of the first video data, determine a position of each of the one or more annotated landmarks with respect to the first position of the camera, map the position of each of the one or more annotated landmarks to the second position of the camera based on the 3D model of the vehicle to determine new landmark positions, and generate, based on the new landmark positions, the second video data. In a fourth example of the method, optionally including one or more or each of the first through third examples, the method further comprises: determining an accuracy of the second video data based on one or more key performance indicators (KPIs). In a fifth example of the method, optionally including one or more or each of the first through fourth examples, the method further comprises:, to determine the accuracy, comparing the second video data to annotated frames of the first video data, wherein the annotated frames of the first video data are considered ground truth for accuracy determination. In a sixth example of the method, optionally including one or more or each of the first through fifth examples, the vehicle system algorithm is one of one or more algorithms of one of an advanced driver assistance system (ADAS) and a driver monitoring system.

The disclosure also provides support for a vehicle, comprising: a camera mounted at a first position, wherein the camera is configured to obtain video of an interior of the vehicle as a plurality of frames, and a driver monitoring system configured with an algorithm for determining driver state based on eye gaze, wherein the algorithm is developed based on first video data acquired with the camera in a second position different than the first position and then updated based on second video data generated based on the first video data, the second video data corresponding to the first position of the camera. In a first example of the system, the second video data is generated by: obtaining the first video data acquired from the second position of the camera, wherein the first video data comprises a plurality of frames, receiving annotations of the plurality of frames of the first video data, obtaining a three-dimensional (3D) model of the vehicle, and deploying a video generation model to generate the second video data based on the first video data, the first position of the camera, the second position of the camera, and the 3D model of the vehicle. In a second example of the system, optionally including the first example, the video generation model is deployed to: detect one or more landmarks within the plurality of frames based on the annotations, determine a position of each of the one or more landmarks with respect to the first position, map the position of each of the one or more landmarks to the first position of the camera based on the 3D model of the vehicle to determine new landmark positions, and generate, based on the new landmark positions, the second video data. In a third example of the system, optionally including one or both of the first and second examples, an accuracy of the video generation model is determined based on one or more Key Performance Indicators (KPIs). In a fourth example of the system, optionally including one or more or each of the first through third examples, the 3D model is a computer aided-design (CAD) model.

As used herein, an element or step recited in the singular and proceeded with the word "a" or "an" should be understood as not excluding plural of said elements or steps, unless such exclusion is explicitly stated. Furthermore, references to "one embodiment" of the present invention are not intended to be interpreted as excluding the existence of additional embodiments that also incorporate the recited features. Moreover, unless explicitly stated to the contrary, embodiments "comprising," "including," or "having" an element or a plurality of elements having a particular property may include additional such elements not having that property. The terms "including" and "in which" are used as the plain-language equivalents of the respective terms "comprising" and "wherein." Moreover, the terms "first," "second," and "third," etc. are used merely as labels, and are not intended to impose numerical requirements or a particular positional order on their objects.

This written description uses examples to disclose the invention, including the best mode, and also to enable a person of ordinary skill in the relevant art to practice the invention, including making and using any devices or systems and performing any incorporated methods. The patentable scope of the invention is defined by the claims, and may include other examples that occur to those of ordinary skill in the art. Such other examples are intended to be within the scope of the claims if they have structural elements that do not differ from the literal language of the claims, or if they include equivalent structural elements with insubstantial differences from the literal languages of the claims.

## Claims

1. A method for generating in-vehicle sensor data, comprising:
obtaining recorded data from one or more in-vehicle sensors positioned in a first vehicle, wherein the recorded data is annotated to indicate one or more landmarks of a subject;
determining a current sensor position of the one or more in-vehicle sensors when the recorded data was obtained;
obtaining a three-dimensional (3D) model of a second vehicle;
determining a target sensor position for newly generated sensor data;
generating, based on the recorded data, the current sensor position, the 3D model, and the target sensor position, new sensor data; and
outputting the new sensor data.

2. The method of claim 1, wherein generating the new sensor data comprises deploying a trained video generation model.

3. The method of claim 1, wherein the first and second vehicles are the same vehicle.

4. The method of claim 1, wherein the recorded data comprises a plurality of annotated frames.

5. The method of claim 4, wherein generating the new sensor data comprises deploying a video generation model to:
detect the one or more landmarks within the plurality of annotated frames;
determine a position of each of the one or more landmarks with respect to the current sensor position;
map the position of each of the one or more landmarks to the target sensor position based on the 3D model of the second vehicle to determine new landmark positions; and
generate, based on the new landmark positions, the new sensor data.

6. The method of claim 1, wherein the first and second vehicles are different vehicles.

7. The method of claim 1, wherein the target sensor position is different from the current sensor position.

8. The method of claim 1, wherein the sensor data is video data and the one or more in-vehicle sensors are cameras mounted in a cabin of the first vehicle.

9. A method for a vehicle, comprising:
acquiring first video data with a camera mounted in a first position in a cabin of the vehicle;
developing a vehicle system algorithm for the vehicle based on the first video data;
generating second video data based on the first video data for a second position of the camera within the cabin of the vehicle, wherein the second video data is generated by a video generation model based on the first video data, the first position of the camera, and a 3D model of the vehicle;
updating the vehicle system algorithm using the second video data;
populating the updated vehicle system algorithm into the vehicle with the camera in the second position; and
following population of the updated vehicle system algorithm, deploying the updated vehicle system algorithm during operation of the vehicle.

10. The method of claim 9, wherein the video generation model is trained on synchronized video frames of a plurality of 3D vehicle models and camera positions within the plurality of 3D vehicle models.

11. The method of claim 9, wherein the 3D model of the vehicle is a computer aided-design (CAD) model.

12. The method of claim 9, wherein the video generation model is configured to:
detect one or more annotated landmarks within annotated frames of the first video data;
determine a position of each of the one or more annotated landmarks with respect to the first position of the camera;
map the position of each of the one or more annotated landmarks to the second position of the camera based on the 3D model of the vehicle to determine new landmark positions; and
generate, based on the new landmark positions, the second video data.

13. The method of claim 9, further comprising determining an accuracy of the second video data based on one or more key performance indicators (KPIs).

14. The method of claim 13, further comprising, to determine the accuracy, comparing the second video data to annotated frames of the first video data, wherein the annotated frames of the first video data are considered ground truth for accuracy determination.

15. The method of claim 9, wherein the vehicle system algorithm is one of one or more algorithms of one of an advanced driver assistance system (ADAS) and a driver monitoring system.

16. A vehicle, comprising:
a camera mounted at a first position, wherein the camera is configured to obtain video of an interior of the vehicle as a plurality of frames; and
a driver monitoring system configured with an algorithm for determining driver state based on eye gaze, wherein the algorithm is developed based on first video data acquired with the camera in a second position different than the first position and then updated based on second video data generated based on the first video data, the second video data corresponding to the first position of the camera.

17. The vehicle of claim 16, wherein the second video data is generated by:
obtaining the first video data acquired from the second position of the camera, wherein the first video data comprises a plurality of frames;
receiving annotations of the plurality of frames of the first video data;
obtaining a three-dimensional (3D) model of the vehicle; and
deploying a video generation model to generate the second video data based on the first video data, the first position of the camera, the second position of the camera, and the 3D model of the vehicle.

18. The vehicle of claim 17, wherein the video generation model is deployed to:
detect one or more landmarks within the plurality of frames based on the annotations;
determine a position of each of the one or more landmarks with respect to the first position;
map the position of each of the one or more landmarks to the first position of the camera based on the 3D model of the vehicle to determine new landmark positions; and
generate, based on the new landmark positions, the second video data.

19. The vehicle of claim 17, wherein an accuracy of the video generation model is determined based on one or more Key Performance Indicators (KPIs).

20. The vehicle of claim 17, wherein the 3D model is a computer aided-design (CAD) model.
